# EUROPEAN PATENT APPLICATION

(11) **EP 4 478 406 A1**
(43) Date of publication of application: **18.12.2024**
(21) Application number: 23214184.6
(22) Date of filing: 05.12.2023
(51) Int. Cl.: H01L 23/00, H01L 23/58, H01L 27/088, H01L 23/48

(54) **BACKSIDE CONTACT BASED DIE EDGE GUARD RINGS**

(30) Priority: 16.06.2023 US 202318211084
(71) Applicant: Intel Corporation, Santa Clara, CA 95054 (US)
(72) Inventor: CHUGH, Sunny, Hillsboro, OR 97124 (US); KASIM, Rahim, Portland, OR 97229 (US); KABIR, Mohammad Enamul, Portland, OR 97229 (US); CHAWLA, Jasmeet S., Hillsboro, OR 97124 (US); KOBRINSKY, Mauro J., Portland, OR 97229 (US); D'SILVA, Joseph, Hillsboro, OR 97124 (US)
(74) Representative: HGF

(57) **Abstract**

Guard rings are described. In an example, a semiconductor die includes an active device layer including a plurality of nanoribbon devices. A dielectric structure is over the active device layer. A first die-edge metal guard ring is in the dielectric structure and around an outer perimeter of the plurality of nanoribbon devices. A plurality of metallization layers is in the dielectric structure and within the first die-edge metal guard ring. A plurality of direct backside contacts extend to the active device layer. A plurality of backside metallization structures is beneath the plurality of direct backside contacts. The plurality of direct backside contacts are connected to the plurality of backside metallization structures. A second die-edge metal guard ring is laterally around the plurality of backside metallization structures.

## Description

### TECHNICAL FIELD

Embodiments of the disclosure are in the field of advanced integrated circuit structure fabrication and, in particular, backside contact based die edge guard rings.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into smaller and smaller nodes. Consequently, fabrication of the functional components needed for future technology nodes may require the introduction of new methodologies or the integration of new technologies in current fabrication processes or in place of current fabrication processes.

### BRIEF DESCRIPTION OF THE DRAWINGS

Figure 1 illustrates a cross-sectional view of a guard ring 100 for a fin-based process flow.
Figure 2 illustrates a cross-sectional view of an integrated circuit structure 120 including a guard ring and a device region for a nanoribbon process flow with only front side contact and no backside contact.
Figure 3 illustrates a cross-sectional view of an integrated circuit structure 150 including a guard ring option 1, a guard ring option 2, and a device region for a nanoribbon process flow with direct backside contact, in accordance with an embodiment of the present disclosure.
Figure 4A illustrates a cross-sectional view of a semiconductor die having a front side only moisture hermetic ring and front side only routing.
Figure 4B illustrates a cross-sectional view of a semiconductor die having a front side only moisture hermetic ring and front side routing and backside direct contact.
Figure 4C illustrates a cross-sectional view of a semiconductor die having a front side only moisture hermetic ring and both front side and backside routing.
Figure 4D illustrates a cross-sectional view of a semiconductor die having direct backside contacts and backside routing and a backside moisture hermetic ring, in accordance with an embodiment of the present disclosure.
Figure 4E illustrates a cross-sectional view of another semiconductor die having direct backside contacts and backside routing and a backside moisture hermetic ring, in accordance with an embodiment of the present disclosure.
Figure 5 illustrates a cross-sectional view of a non-planar integrated circuit structure as taken along a gate line, in accordance with an embodiment of the present disclosure.
Figure 6A illustrates a three-dimensional cross-sectional view of a nanowire-based integrated circuit structure, in accordance with an embodiment of the present disclosure.
Figure 6B illustrates a cross-sectional source or drain view of the nanowire-based integrated circuit structure of Figure 6A, as taken along the a-a' axis, in accordance with an embodiment of the present disclosure.
Figure 6C illustrates a cross-sectional channel view of the nanowire-based integrated circuit structure of Figure 6A, as taken along the b-b' axis, in accordance with an embodiment of the present disclosure.
Figure 7 illustrates a cross-sectional view of an integrated circuit structure having four metallization layers with a metal line composition and pitch above two metallization layers with a differing metal line composition and smaller pitch, in accordance with an embodiment of the present disclosure.
Figure 8 illustrates a computing device in accordance with one implementation of the disclosure.
Figure 9 illustrates an interposer that includes one or more embodiments of the disclosure.
Figure 10 is an isometric view of a mobile computing platform employing an IC fabricated according to one or more processes described herein or including one or more features described herein, in accordance with an embodiment of the present disclosure.
Figure 11 illustrates a cross-sectional view of a flip-chip mounted die, in accordance with an embodiment of the present disclosure.

### DESCRIPTION OF THE EMBODIMENTS

Backside contact based die edge guard rings are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions or context for terms found in this disclosure (including the appended claims):
"Comprising." This term is open-ended. As used in the appended claims, this term does not foreclose additional structure or operations.

"Configured To." Various units or components may be described or claimed as "configured to" perform a task or tasks. In such contexts, "configured to" is used to connote structure by indicating that the units or components include structure that performs those task or tasks during operation. As such, the unit or component can be said to be configured to perform the task even when the specified unit or component is not currently operational (e.g., is not on or active). Reciting that a unit or circuit or component is "configured to" perform one or more tasks is expressly intended not to invoke 35 U.S.C. §112, sixth paragraph, for that unit or component.

"First," "Second," etc. As used herein, these terms are used as labels for nouns that they precede, and do not imply any type of ordering (e.g., spatial, temporal, logical, etc.).

"Coupled" - The following description refers to elements or nodes or features being "coupled" together. As used herein, unless expressly stated otherwise, "coupled" means that one element or node or feature is directly or indirectly joined to (or directly or indirectly communicates with) another element or node or feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation or location or both of portions of the component within a consistent but arbitrary frame of reference which is made clear by reference to the text and the associated drawings describing the component under discussion. Such terminology may include the words specifically mentioned above, derivatives thereof, and words of similar import.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, or effect which might otherwise occur. Accordingly, when a component, element, or feature is referred to as inhibiting a result or state, it need not completely prevent or eliminate the result or state.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) get interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modem IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

In accordance with one or more embodiments of the present disclosure, backside contact based die edge guard ring solutions are described. One or more embodiments are directed to a hermetic die-edge rings for structures having direct backside contacts for nanoribbon based devices (where the term nanoribbon can also refer to nanowire or nanosheet).

To provide context, a direct backside contact with a nanoribbon transistor is one of the key features to enable technology scaling. A reliable solution to prevent moisture breach and achieve crack arrest at the die edge is needed that is compatible with the direct backside contact scheme.

In accordance with one or more embodiments of the present disclosure, an approach is provided to land a front side contact directly on a backside contact in the die edge guard ring region without any nanoribbon in between thereby resulting in a full metal wall. Advantages for implementing embodiments described herein can include achieving a fully hermetic seal around a die that will protect the internal circuity (metals and dielectrics) from moisture damage over the lifetime of a product and also help with crack arrest.

Implementation of embodiments described herein can be revealed by a full metal wall that is present in the die edge guard ring region. Reverse engineering techniques such as TEM in the guard ring region will highlight such features.

To provide further context, nanoribbon (or Gate All Around, GAA) transistor and backside power delivery (PowerVia) are some of the key drivers to enable technology scaling beyond a FINFET process flow. The typical nanoribbon flow uses a deep boundary via (DVB) that connects the front-side transistor contact to the backside metal layers. To enable further logic scaling, one of the primary options is to directly land a backside contact on the nanoribbon.

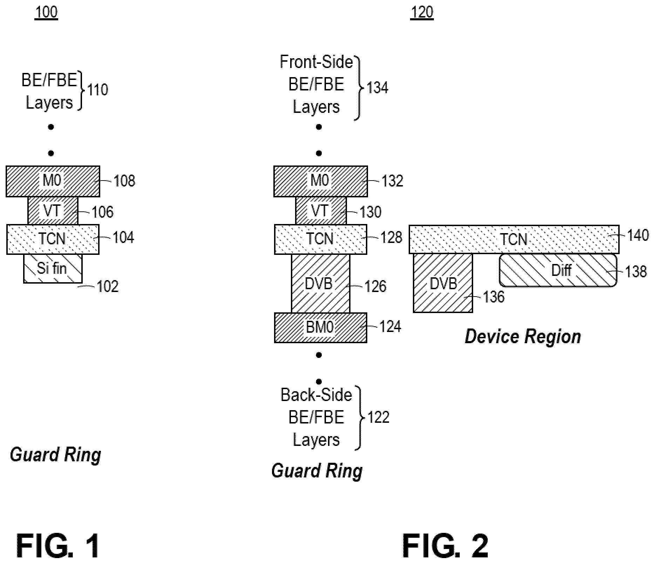

For all the architectures described above, it is imperative to develop a die etch guard ring scheme that prevents moisture breach into the active circuitry during the product use and assists against die cracking. For the FINFET flow, the guard ring solution that has been implemented in the industry is shown in the Figure 1.

Figure 1 illustrates a cross-sectional view of a guard ring 100 for a fin-based process flow. The guard ring 100 includes an Si fin 102, a trench contact 104, a trench via 106, a lowest metallization layer 108, and backend (BE)/far backend (FBE) layers 110.

For a nanoribbon flow with only a front side contact, a deep boundary via or deep via bar (DVB) connects to the back-metal layer BM0 and forms a full metallic wall that acts as the guard ring, as shown in Figure 2.

Figure 2 illustrates a cross-sectional view of an integrated circuit structure 120 including a guard ring and a device region for a nanoribbon process flow with only front side contact and no backside contact. The guard ring includes backend (BE)/far backend (FBE) layers 122, a first backside metal layer 124, a deep via bar 126, a trench contact 128, a trench via 130, a lowest metallization layer 132, and backend (BE)/far backend (FBE) layers 134. The device region includes a deep via bar 136, a diffusion region or structure 138, and a trench contact 140.

In accordance with one or more embodiments of the present disclosure, a guard ring scheme is described that provides a solution for the nanoribbon flow with a direct backside contact.

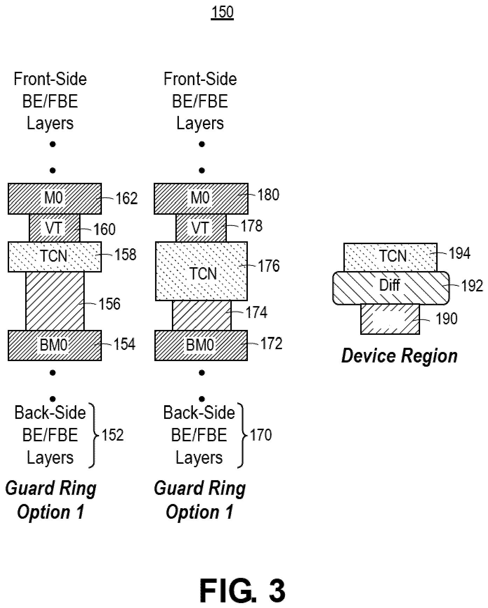

Figure 3 illustrates a cross-sectional view of an integrated circuit structure 150 including a guard ring option 1, a guard ring option 2, and a device region for a nanoribbon process flow with direct backside contact, in accordance with an embodiment of the present disclosure. It is to be appreciated that FinFET structures can be used in place of nanoribbon structures.

Referring to Figure 3, the guard ring option 1 includes backend (BE)/far backend (FBE) layers 152, a first backside metal layer 154, a direct backside contact 156, a trench contact 158, a trench via 160, a lowest metallization layer 162, and backend (BE)/far backend (FBE) layers. The guard ring option 2 includes backend (BE)/far backend (FBE) layers 170, a first backside metal layer 172, a direct backside contact 174, a trench contact 176, a trench via 178, a lowest metallization layer 180, and backend (BE)/far backend (FBE) layers. The device region includes a direct backside contact 190, a diffusion region or structure 192, and a trench contact 194.

With reference again to Figure 3, the structure 150 includes a nanoribbon in the device region with the front side contact (TCN) 194 and direct backside contact 190 landing on the nanoribbon 192. Since a gate oxide around the nanoribbon is not hermetic, if such a configuration is used in the guard ring, it may not work as an effective option. In an embodiment, two guard ring options are provided to achieve an effective metal guard ring. With option 1, the direct contact 156 is etched and filled with metal deeper than in the device region. Similarly, with option 2, the TCN layer 176 is etched and filled with metal deeper than the TCN in the device region.

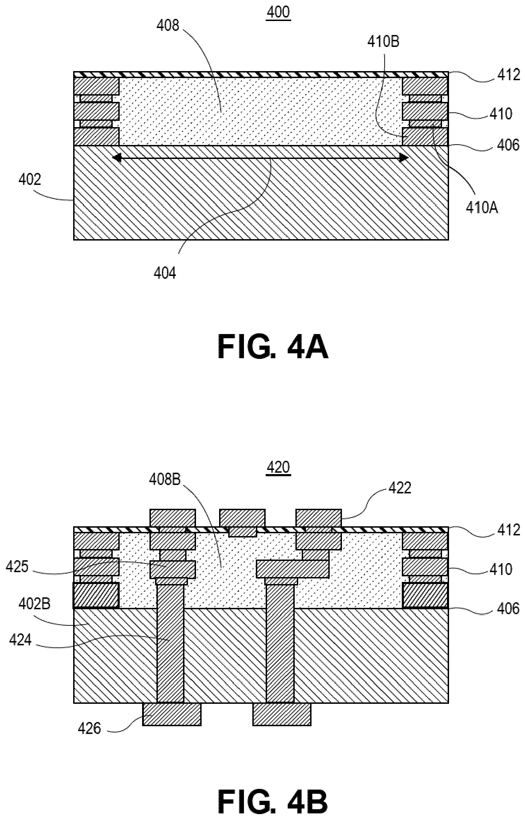

As a comparative structure, Figure 4A illustrates a cross-sectional view of a semiconductor die having a front side only moisture hermetic ring and front side only routing.

Referring to Figure 4A, a semiconductor die 400 includes a substrate or backside layer 402. An active die area 404 can represent a region where an active device layer 406 such as a transistor layer is on the substrate or backside layer 402. A dielectric structure 408, which can include numerous layers of dielectric and/or insulating materials, is over the active device layer 406. A die-edge metal guard ring 410 is around the outer perimeter of the substrate 408 and, as is to be appreciated, can form a ring or frame around the active device layer 406 (use of the term ring can encompass a square or rectangular or other frame). The die-edge metal guard ring 410 can include multiple layers of alternating metal lines 410B and vias 410A, as is depicted. A hermetic passivation layer 412, such as a silicon nitride or polyimide layer, is over the dielectric structure 408 and the die-edge metal guard ring 410.

As another comparative structure, Figure 4B illustrates a cross-sectional view of a semiconductor die having a front side only moisture hermetic ring and front side routing and backside direct contact.

Referring to Figure 4B, a semiconductor die 420 includes a bottom dielectric layer 402B, such as a dielectric layer formed following residual substrate and/or sub-fin removal and replacement with dielectric material. An active device layer 406, such as a transistor layer, is above the bottom dielectric layer 402B. A dielectric structure 408B, which can include numerous layers of dielectric and/or insulating materials, is over the active device layer 406. A die-edge metal guard ring 410 is around the outer perimeter of the active device layer 406 and, as is to be appreciated, can form a ring or frame around the active device layer 406 (use of the term ring can encompass a square or rectangular or other frame). The die-edge metal guard ring 410 can include multiple layers of alternating metal lines and vias, as is depicted. A hermetic passivation layer 412, such as a silicon nitride or other hermetic layer, is over the dielectric structure 408B and the die-edge metal guard ring 410. Direct backside contacts 424 are coupled to back-end-of-line (BEOL) metallization layers 425 within a perimeter of the die-edge metal guard ring 410. Direct backside contacts 424 can represent a combination of features 174/176 of Figure 3 or a combination of features 156/158 of Figure 3. The BEOL metallization layers 425 are coupled to bumps 422, e.g., for connecting to a top die. The direct backside contacts 424 are coupled to a first backside metallization layer 426.

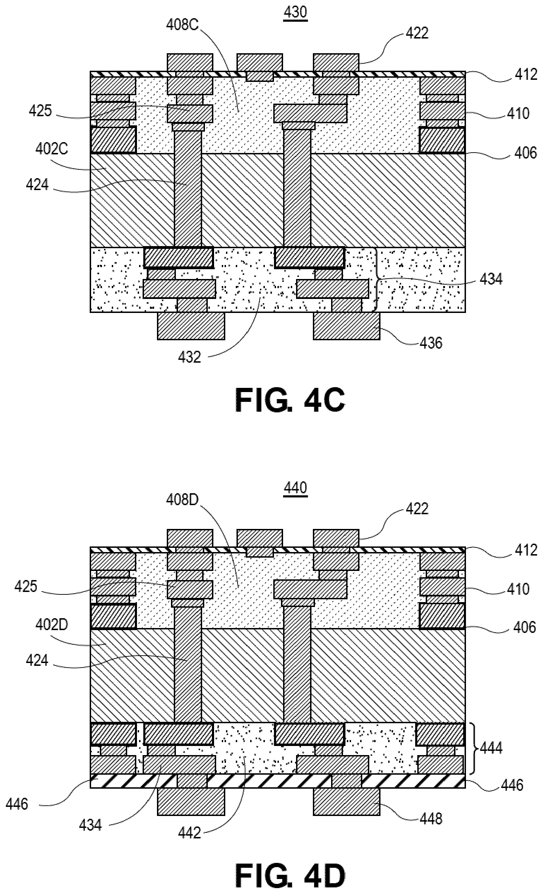

As another comparative structure, Figure 4C illustrates a cross-sectional view of a semiconductor die having a front side only moisture hermetic ring and both front side and backside routing.

Referring to Figure 4C, a semiconductor die 430 includes a bottom dielectric layer 402C, such as a dielectric layer formed following residual substrate and/or sub-fin removal and replacement with dielectric material. An active device layer 406, such as a transistor layer, is above the bottom dielectric layer 402C. A dielectric structure 408C, which can include numerous layers of dielectric and/or insulating materials, is over the active device layer 406. A die-edge metal guard ring 410 is around the outer perimeter of the active device layer 406 and, as is to be appreciated, can form a ring or frame around the active device layer 406 (use of the term ring can encompass a square or rectangular or other frame). The die-edge metal guard ring 410 can include multiple layers of alternating metal lines and vias, as is depicted. A hermetic passivation layer 412, such as a silicon nitride or other hermetic layer, is over the dielectric structure 408C and the die-edge metal guard ring 410. Direct backside contacts 424 are coupled to back-end-of-line (BEOL) metallization layers 425 within a perimeter of the die-edge metal guard ring 410. Direct backside contacts 424 can represent a combination of features 174/176 of Figure 3 or of a combination of features 156/158 of Figure 3. The BEOL metallization layers 425 are coupled to bumps 422, e.g., for connecting to a top die. The direct backside contacts 424 are also coupled to backside metallization structures 434 (also referred to as package-side routing) which can be included in a dielectric layer or stack of layers 432. The backside metallization structures 434 are coupled to package side bumps 436, e.g., for coupling to a package substrate or to a board.

Embodiments can be implemented to provide a hermetic ring around a backside of a direct backside contact structure.

As an exemplary structure, Figure 4D illustrates a cross-sectional view of a semiconductor die having direct backside contacts and backside routing and a backside moisture hermetic ring, in accordance with an embodiment of the present disclosure.

Referring to Figure 4D, a semiconductor die 440 includes a bottom dielectric layer 402D, such as a dielectric layer formed following residual substrate and/or sub-fin removal and replacement with dielectric material. An active device layer 406, such as a transistor layer, is above the bottom dielectric layer 402D. A dielectric structure 408D, which can include numerous layers of dielectric and/or insulating materials, is over the active device layer 406. A die-edge metal guard ring 410 is around the outer perimeter of the active device layer 406 and, as is to be appreciated, can form a ring or frame around the active device layer 406 (use of the term ring can encompass a square or rectangular or other frame). The die-edge metal guard ring 410 can include multiple layers of alternating metal lines and vias, as is depicted. A hermetic passivation layer 412, such as a silicon nitride or other hermetic layer, is over the dielectric structure 408D and the die-edge metal guard ring 410. Direct backside contacts 424 are coupled to back-end-of-line (BEOL) metallization layers 425 within a perimeter of the die-edge metal guard ring 410. Direct backside contacts 424 can represent a combination of features 174/176 of Figure 3 or of a combination of features 156/158 of Figure 3. The BEOL metallization layers 425 are coupled to bumps 422, e.g., for connecting to a top die. The direct backside contacts 424 are also coupled to backside metallization structures 434 (also referred to as package-side routing) which can be included in a dielectric layer or stack of layers 442. The backside metallization structures 434 are coupled to package side bumps 448, e.g., for coupling to a package substrate or to a board. A second die-edge metal guard ring 444 is around the outer perimeter of the backside of substrate 402D and, as is to be appreciated, can form a ring or frame around the backside metallization structures 434 (use of the term ring can encompass a square or rectangular or other frame). The second die-edge metal guard ring 444 can include multiple layers of alternating metal lines and vias, as is depicted. A second hermetic passivation layer 446, such as a silicon nitride or polyimide layer, is beneath the dielectric structure 442 and the second die-edge metal guard ring 444.

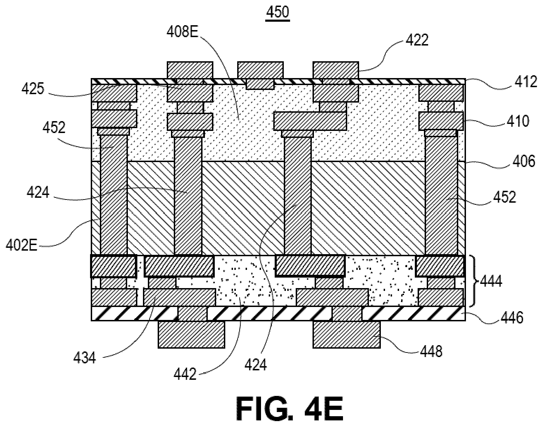

As an exemplary structure, Figure 4E illustrates a cross-sectional view of another semiconductor die having direct backside contacts and backside routing and a backside moisture hermetic ring, in accordance with an embodiment of the present disclosure.

Referring to Figure 4E, a semiconductor die 450 includes a bottom dielectric layer 402E, such as a dielectric layer formed following residual substrate and/or sub-fin removal and replacement with dielectric material. An active device layer 406, such as a transistor layer, is above the bottom dielectric layer 402E. A dielectric structure 408E, which can include numerous layers of dielectric and/or insulating materials, is over the active device layer 406. A die-edge metal guard ring 410 is around the outer perimeter of the substrate or backside layer 402E and, as is to be appreciated, can form a ring or frame around the active device layer 406 (use of the term ring can encompass a square or rectangular or other frame). The die-edge metal guard ring 410 can include multiple layers of alternating metal lines and vias, as is depicted. A hermetic passivation layer 412, such as a silicon nitride or polyimide layer, is over the dielectric structure 408E and the die-edge metal guard ring 410. Direct backside contacts 424 are coupled to back-end-of-line (BEOL) metallization layers 425 within a perimeter of the die-edge metal guard ring 410. Direct backside contacts 424 can represent a combination of features 174/176 of Figure 3 or of a combination of features 156/158 of Figure 3. The BEOL metallization layers 425 are coupled to bumps 422, e.g., for connecting to a top die. The direct backside contacts are also coupled to backside metallization structures 434 (also referred to as package-side routing) which can be included in a dielectric layer or stack of layers 442. The backside metallization structures 434 are coupled to package side bumps 448, e.g., for coupling to a package substrate or to a board. A second die-edge metal guard ring 444 is around the outer perimeter of the backside of substrate or backside layer 402E and, as is to be appreciated, can form a ring or frame around the backside metallization structures 434 (use of the term ring can encompass a square or rectangular or other frame). The second die-edge metal guard ring 444 can include multiple layers of alternating metal lines and vias, as is depicted. A second hermetic passivation layer 446, such as a silicon nitride or polyimide layer, is beneath the dielectric structure 442 and the second die-edge metal guard ring 444. A direct backside contact wall 452 couples the die-edge metal guard ring 410 to the second die-edge metal guard ring 444. The direct backside contact wall can be a single unitary conductive structure. As is to be appreciated, the direct backside contact wall 452 can form a ring or frame (use of the term ring can encompass a square or rectangular or other frame).

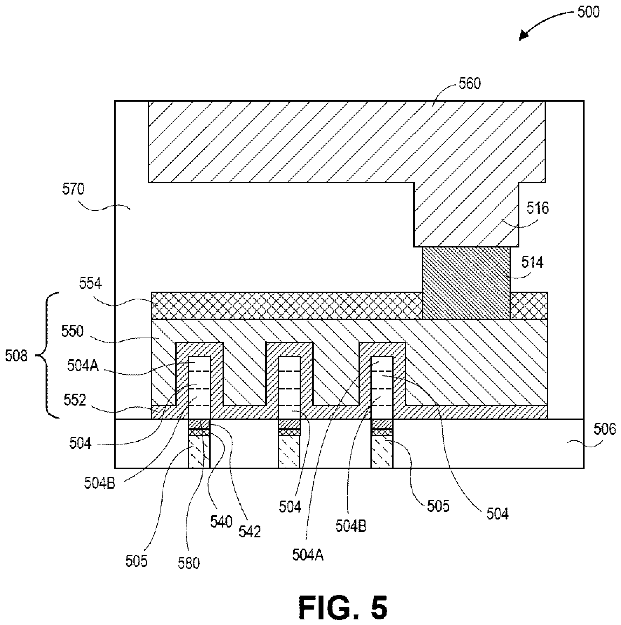

It is to be appreciated that the structures resulting from the above exemplary processing schemes may be used in a same or similar form together with processing operations for device fabrication, such as PMOS and/or NMOS device fabrication. As an example of a completed device that can be included with backside contact based die edge guard rings, Figure 5 illustrates a cross-sectional view of a non-planar integrated circuit structure as taken along a gate line, in accordance with an embodiment of the present disclosure.

Referring to Figure 5, a semiconductor structure or device 500 includes a non-planar active region (e.g., a fin structure including protruding fin portion 504 and sub-fin region 505) within a trench isolation region 506. In an embodiment, instead of a solid fin, the non-planar active region is separated into nanowires (such as nanowires 504A and 504B) above sub-fin region 505, as is represented by the dashed lines. In either case, for ease of description for non-planar integrated circuit structure 500, a non-planar active region 504 is referenced below as a protruding fin portion. In an embodiment, the sub-fin region 505 also includes a relaxed buffer layer 542 and a defect modification layer 540, as is depicted.

A gate line 508 is disposed over the protruding portions 504 of the non-planar active region (including, if applicable, surrounding nanowires 504A and 504B), as well as over a portion of the trench isolation region 506. As shown, gate line 508 includes a gate electrode 550 and a gate dielectric layer 552. In one embodiment, gate line 508 may also include a dielectric cap layer 554. A gate contact 514, and overlying gate contact via 516 are also seen from this perspective, along with an overlying metal interconnect 560, all of which are disposed in inter-layer dielectric stacks or layers 570. Also seen from the perspective of Figure 5, the gate contact 514 is, in one embodiment, disposed over trench isolation region 506, but not over the non-planar active regions. In another embodiment, the gate contact 514 is over the non-planar active regions.

In an embodiment, the semiconductor structure or device 500 is a non-planar device such as, but not limited to, a fin-FET device, a tri-gate device, a nanoribbon device, or a nanowire device. In such an embodiment, a corresponding semiconducting channel region is composed of or is formed in a three-dimensional body. In one such embodiment, the gate electrode stacks of gate lines 508 surround at least a top surface and a pair of sidewalls of the three-dimensional body.

As is also depicted in Figure 5, in an embodiment, an interface 580 exists between a protruding fin portion 504 and sub-fin region 505. The interface 580 can be a transition region between a doped sub-fin region 505 and a lightly or undoped upper fin portion 504. In one such embodiment, each fin is approximately 10 nanometers wide or less, and sub-fin dopants are optionally supplied from an adjacent solid state doping layer at the sub-fin location. In a particular such embodiment, each fin is less than 10 nanometers wide.

Although not depicted in Figure 5, it is to be appreciated that source or drain regions of or adjacent to the protruding fin portions 504 are on either side of the gate line 508, i.e., into and out of the page. In one embodiment, the material of the protruding fin portions 504 in the source or drain locations is removed and replaced with another semiconductor material, e.g., by epitaxial deposition to form epitaxial source or drain structures. The source or drain regions may extend below the height of dielectric layer of trench isolation region 506, i.e., into the sub-fin region 505. In accordance with an embodiment of the present disclosure, the more heavily doped sub-fin regions, i.e., the doped portions of the fins below interface 580, inhibits source to drain leakage through this portion of the bulk semiconductor fins. In an embodiment, the source and drain regions have associated asymmetric source and drain contact structures.

With reference again to Figure 5, in an embodiment, fins 504/505 (and, possibly nanowires 504A and 504B) are composed of a crystalline silicon germanium layer which may be doped with a charge carrier, such as but not limited to phosphorus, arsenic, boron, gallium or a combination thereof.

In an embodiment, trench isolation region 506, and trench isolation regions (trench isolations structures or trench isolation layers) described throughout, may be composed of a material suitable to ultimately electrically isolate, or contribute to the isolation of, portions of a permanent gate structure from an underlying bulk substrate or isolate active regions formed within an underlying bulk substrate, such as isolating fin active regions. For example, in one embodiment, trench isolation region 506 is composed of a dielectric material such as, but not limited to, silicon dioxide, silicon oxy-nitride, silicon nitride, or carbon-doped silicon nitride.

Gate line 508 may be composed of a gate electrode stack which includes a gate dielectric layer 552 and a gate electrode layer 550. In an embodiment, the gate electrode of the gate electrode stack is composed of a metal gate and the gate dielectric layer is composed of a high-k material. For example, in one embodiment, the gate dielectric layer 552 is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of gate dielectric layer 552 may include a layer of native oxide formed from the top few layers of the substrate fin 504. In an embodiment, the gate dielectric layer 552 is composed of a top high-k portion and a lower portion composed of an oxide of a semiconductor material. In one embodiment, the gate dielectric layer 552 is composed of a top portion of hafnium oxide and a bottom portion of silicon dioxide or silicon oxy-nitride. In some implementations, a portion of the gate dielectric is a "U"-shaped structure that includes a bottom portion substantially parallel to the surface of the substrate and two sidewall portions that are substantially perpendicular to the top surface of the substrate.

In one embodiment, the gate electrode layer 550 is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode layer 550 is composed of a non-workfunction-setting fill material formed above a metal workfunction-setting layer. The gate electrode layer 550 may consist of a P-type workfunction metal or an N-type workfunction metal, depending on whether the transistor is to be a PMOS or an NMOS transistor. In some implementations, the gate electrode layer 550 may consist of a stack of two or more metal layers, where one or more metal layers are workfunction metal layers and at least one metal layer is a conductive fill layer. For a PMOS transistor, metals that may be used for the gate electrode include, but are not limited to, ruthenium, palladium, platinum, cobalt, nickel, tungsten and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV. In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode may consist of one or more U-shaped metal layers formed atop one or more planar, non-U-shaped layers.

Spacers associated with the gate electrode stacks may be composed of a material suitable to ultimately electrically isolate, or contribute to the isolation of, a permanent gate structure from adjacent conductive contacts, such as self-aligned contacts. For example, in one embodiment, the spacers are composed of a dielectric material such as, but not limited to, silicon dioxide, silicon oxy-nitride, silicon nitride, or carbon-doped silicon nitride.

Gate contact 514 and overlying gate contact via 516 may be composed of a conductive material. In an embodiment, one or more of the contacts or vias are composed of a metal species. The metal species may be a pure metal, such as tungsten, nickel, or cobalt, or may be an alloy such as a metal-metal alloy or a metal-semiconductor alloy (e.g., such as a silicide material).

In an embodiment (although not shown), a contact pattern which is essentially perfectly aligned to an existing gate pattern 508 is formed while eliminating the use of a lithographic step with exceedingly tight registration budget. In an embodiment, the contact pattern is a vertically symmetric contact pattern, or an asymmetric contact pattern. In other embodiments, all contacts are front side connected and are not asymmetric. In one such embodiment, the self-aligned approach enables the use of intrinsically highly selective wet etching (e.g., versus conventionally implemented dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in conventional approaches. In an embodiment, a trench contact grid is not separately patterned, but is rather formed between poly (gate) lines. For example, in one such embodiment, a trench contact grid is formed subsequent to gate grating patterning but prior to gate grating cuts.

In an embodiment, providing structure 500 involves fabrication of the gate stack structure 508 by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of polycrystalline silicon or amorphous silicon and are removed with a dry etch process including use of SF₆. In another embodiment, dummy gates are composed of polycrystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

Referring again to Figure 5, the arrangement of semiconductor structure or device 500 places the gate contact over isolation regions. Such an arrangement may be viewed as inefficient use of layout space. In another embodiment, however, a semiconductor device has contact structures that contact portions of a gate electrode formed over an active region, e.g., over a sub-fin 505, and in a same layer as a trench contact via.

In an embodiment, the structure of Figure 5 can be formed using a pixel structure cut approach, such as described above.

It is to be appreciated that not all aspects of the processes described above need be practiced to fall within the spirit and scope of embodiments of the present disclosure. Also, the processes described herein may be used to fabricate one or a plurality of semiconductor devices. The semiconductor devices may be transistors or like devices. For example, in an embodiment, the semiconductor devices are a metal-oxide semiconductor (MOS) transistors for logic or memory, or are bipolar transistors. Also, in an embodiment, the semiconductor devices have a three-dimensional architecture, such as a nanowire device, a nanoribbon device, a tri-gate device, an independently accessed double gate device, or a FIN-FET. One or more embodiments may be particularly useful for fabricating semiconductor devices at a sub-10 nanometer (10 nm) technology node.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiOz)), doped oxides of silicon, fluorinated oxides of silicon, carbon doped oxides of silicon, various low-k dielectric materials known in the arts, and combinations thereof. The interlayer dielectric material may be formed by conventional techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials, capping layers, or plugs are composed of dielectric materials different from the interlayer dielectric material. In one embodiment, different hardmask, capping or plug materials may be used in different regions so as to provide different growth or etch selectivity to each other and to the underlying dielectric and metal layers. In some embodiments, a hardmask layer, capping or plug layer includes a layer of a nitride of silicon (e.g., silicon nitride) or a layer of an oxide of silicon, or both, or a combination thereof. Other suitable materials may include carbon-based materials. Other hardmask, capping or plug layers known in the arts may be used depending upon the particular implementation. The hardmask, capping or plug layers maybe formed by CVD, PVD, or by other deposition methods.

In an embodiment, as is also used throughout the present description, lithographic operations are performed using 193nm immersion lithography (i193), EUV and/or EBDW lithography, or the like. A positive tone or a negative tone resist may be used. In one embodiment, a lithographic mask is a tri-layer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

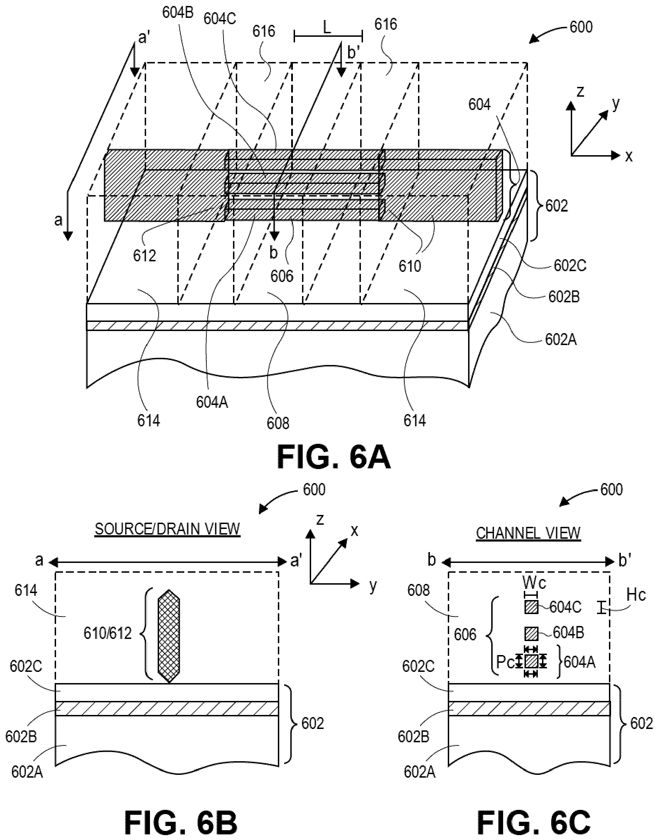

To highlight an exemplary integrated circuit structure having three vertically arranged nanowires, Figure 6A illustrates a three-dimensional cross-sectional view of a nanowire-based integrated circuit structure, in accordance with an embodiment of the present disclosure. Figure 6B illustrates a cross-sectional source or drain view of the nanowire-based integrated circuit structure of Figure 6A, as taken along the a-a' axis. Figure 6C illustrates a cross-sectional channel view of the nanowire-based integrated circuit structure of Figure 6A, as taken along the b-b' axis.

Referring to Figure 6A, an integrated circuit structure 600 includes one or more vertically stacked nanowires (604 set) above a substrate 602. In an embodiment, as depicted, a relaxed buffer layer 602C, a defect modification layer 602B, and a lower substrate portion 602A are included in substrate 602, as is depicted. An optional fin below the bottommost nanowire and formed from the substrate 602 is not depicted for the sake of emphasizing the nanowire portion for illustrative purposes. Embodiments herein are targeted at both single wire devices and multiple wire devices. As an example, a three nanowire-based devices having nanowires 604A, 604B and 604C is shown for illustrative purposes. For convenience of description, nanowire 604A is used as an example where description is focused on one of the nanowires. It is to be appreciated that where attributes of one nanowire are described, embodiments based on a plurality of nanowires may have the same or essentially the same attributes for each of the nanowires.

Each of the nanowires 604 includes a channel region 606 in the nanowire. The channel region 606 has a length (L). Referring to Figure 6C, the channel region also has a perimeter (Pc) orthogonal to the length (L). Referring to both Figures 6A and 6C, a gate electrode stack 608 surrounds the entire perimeter (Pc) of each of the channel regions 606. The gate electrode stack 608 includes a gate electrode along with a gate dielectric layer between the channel region 606 and the gate electrode (not shown). In an embodiment, the channel region is discrete in that it is completely surrounded by the gate electrode stack 608 without any intervening material such as underlying substrate material or overlying channel fabrication materials. Accordingly, in embodiments having a plurality of nanowires 604, the channel regions 606 of the nanowires are also discrete relative to one another.

Referring to both Figures 6A and 6B, integrated circuit structure 600 includes a pair of non-discrete source or drain regions 610/612. The pair of non-discrete source or drain regions 610/612 is on either side of the channel regions 606 of the plurality of vertically stacked nanowires 604. Furthermore, the pair of non-discrete source or drain regions 610/612 is adjoining for the channel regions 606 of the plurality of vertically stacked nanowires 604. In one such embodiment, not depicted, the pair of non-discrete source or drain regions 610/612 is directly vertically adjoining for the channel regions 606 in that epitaxial growth is on and between nanowire portions extending beyond the channel regions 606, where nanowire ends are shown within the source or drain structures. In another embodiment, as depicted in Figure 6A, the pair of non-discrete source or drain regions 610/612 is indirectly vertically adjoining for the channel regions 606 in that they are formed at the ends of the nanowires and not between the nanowires.

In an embodiment, as depicted, the source or drain regions 610/612 are non-discrete in that there are not individual and discrete source or drain regions for each channel region 606 of a nanowire 604. Accordingly, in embodiments having a plurality of nanowires 604, the source or drain regions 610/612 of the nanowires are global or unified source or drain regions as opposed to discrete for each nanowire. That is, the non-discrete source or drain regions 610/612 are global in the sense that a single unified feature is used as a source or drain region for a plurality (in this case, 3) of nanowires 604 and, more particularly, for more than one discrete channel region 606. In one embodiment, from a cross-sectional perspective orthogonal to the length of the discrete channel regions 606, each of the pair of non-discrete source or drain regions 610/612 is approximately rectangular in shape with a bottom tapered portion and a top vertex portion, as depicted in Figure 6B. In other embodiments, however, the source or drain regions 610/612 of the nanowires are relatively larger yet discrete non-vertically merged epitaxial structures such as nubs.

In accordance with an embodiment of the present disclosure, and as depicted in Figures 6A and 6B, integrated circuit structure 600 further includes a pair of contacts 614, each contact 614 on one of the pair of non-discrete source or drain regions 610/612. In one such embodiment, in a vertical sense, each contact 614 completely surrounds the respective non-discrete source or drain region 610/612. In another aspect, the entire perimeter of the non-discrete source or drain regions 610/612 may not be accessible for contact with contacts 614, and the contact 614 thus only partially surrounds the non-discrete source or drain regions 610/612, as depicted in Figure 6B. In a contrasting embodiment, not depicted, the entire perimeter of the non-discrete source or drain regions 610/612, as taken along the a-a' axis, is surrounded by the contacts 614.

Referring again to Figure 6A, in an embodiment, integrated circuit structure 600 further includes a pair of spacers 616. As is depicted, outer portions of the pair of spacers 616 may overlap portions of the non-discrete source or drain regions 610/612, providing for "embedded" portions of the non-discrete source or drain regions 610/612 beneath the pair of spacers 616. As is also depicted, the embedded portions of the non-discrete source or drain regions 610/612 may not extend beneath the entirety of the pair of spacers 616.

Substrate 602 may be composed of a material suitable for integrated circuit structure fabrication. In one embodiment, substrate 602 includes a lower bulk substrate composed of a single crystal of a material which may include, but is not limited to, silicon, germanium, silicon-germanium, germanium-tin, silicon-germanium-tin, or a group III-V compound semiconductor material. An upper insulator layer composed of a material which may include, but is not limited to, silicon dioxide, silicon nitride or silicon oxy-nitride is on the lower bulk substrate. Thus, the structure 600 may be fabricated from a starting semiconductor-on-insulator substrate. Alternatively, the structure 600 is formed directly from a bulk substrate and local oxidation is used to form electrically insulative portions in place of the above described upper insulator layer. In another alternative embodiment, the structure 600 is formed directly from a bulk substrate and doping is used to form electrically isolated active regions, such as nanowires, thereon. In one such embodiment, the first nanowire (i.e., proximate the substrate) is in the form of an omega-FET type structure.

In an embodiment, the nanowires 604 may be sized as wires or ribbons, as described below, and may have squared-off or rounder corners. In an embodiment, the nanowires 604 are composed of a material such as, but not limited to, silicon, germanium, or a combination thereof. In one such embodiment, the nanowires are single-crystalline. For example, for a silicon nanowire 604, a single-crystalline nanowire may be based from a (100) global orientation, e.g., with a <100> plane in the z-direction. As described below, other orientations may also be considered. In an embodiment, the dimensions of the nanowires 604, from a cross-sectional perspective, are on the nano-scale. For example, in a specific embodiment, the smallest dimension of the nanowires 604 is less than approximately 20 nanometers. In an embodiment, the nanowires 604 are composed of a strained material, particularly in the channel regions 606.

Referring to Figures 6C, in an embodiment, each of the channel regions 606 has a width (Wc) and a height (Hc), the width (Wc) approximately the same as the height (He). That is, in both cases, the channel regions 606 are square-like or, if corner-rounded, circle-like in cross-section profile. In another aspect, the width and height of the channel region need not be the same, such as the case for nanoribbons as described throughout.

In an embodiment, as described throughout, an integrated circuit structure includes non-planar devices such as, but not limited to, a finFET or a tri-gate device with corresponding one or more overlying nanowire structures. In such an embodiment, a corresponding semiconducting channel region is composed of or is formed in a three-dimensional body with one or more discrete nanowire channel portions overlying the three-dimensional body. In one such embodiment, the gate structures surround at least a top surface and a pair of sidewalls of the three-dimensional body, and further surrounds each of the one or more discrete nanowire channel portions.

In an embodiment, the structure of Figures 6A-6C can be formed using a pixel structure cut approach, such as described above.

In an embodiment, as described throughout, an underlying substrate may be composed of a semiconductor material that can withstand a manufacturing process and in which charge can migrate. In an embodiment, the substrate is a bulk substrate composed of a crystalline silicon, silicon/germanium or germanium layer doped with a charge carrier, such as but not limited to phosphorus, arsenic, boron, gallium or a combination thereof, to form an active region. In one embodiment, the concentration of silicon atoms in a bulk substrate is greater than 97%. In another embodiment, a bulk substrate is composed of an epitaxial layer grown atop a distinct crystalline substrate, e.g. a silicon epitaxial layer grown atop a boron-doped bulk silicon mono-crystalline substrate. A bulk substrate may alternatively be composed of a group III-V material. In an embodiment, a bulk substrate is composed of a group III-V material such as, but not limited to, gallium nitride, gallium phosphide, gallium arsenide, indium phosphide, indium antimonide, indium gallium arsenide, aluminum gallium arsenide, indium gallium phosphide, or a combination thereof. In one embodiment, a bulk substrate is composed of a group III-V material and the charge-carrier dopant impurity atoms are ones such as, but not limited to, carbon, silicon, germanium, oxygen, sulfur, selenium or tellurium.

In another aspect, back-end-of-line (BEOL) layers of integrated circuits commonly include electrically conductive microelectronic structures, which are known in the art as vias, to electrically connect metal lines or other interconnects above the vias to metal lines or other interconnects below the vias. In accordance with one or more embodiments of the present disclosure, a backside contact based die edge guard rings as described above is included with a BEOL structure of an integrated circuit.

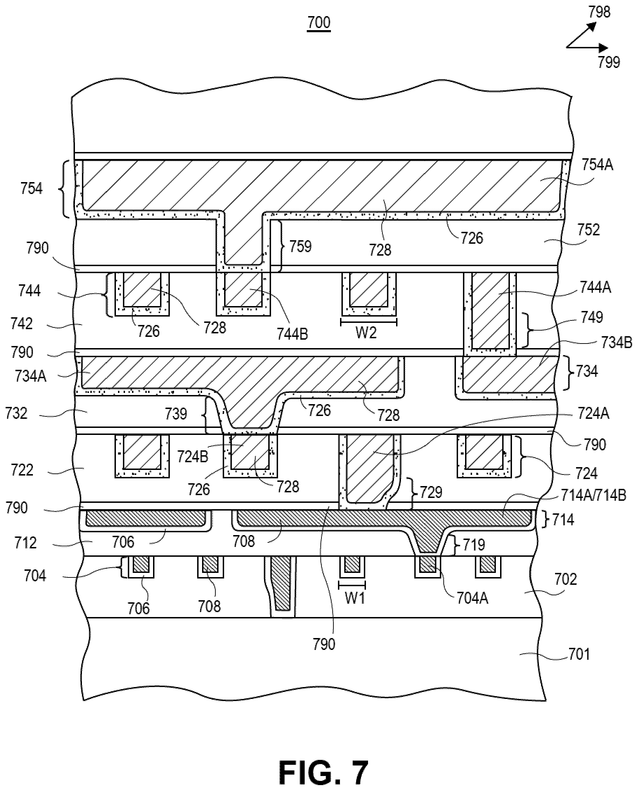

As an exemplary but non-limiting BEOL structure, Figure 7 illustrates a cross-sectional view of an integrated circuit structure having four metallization layers with a metal line composition and pitch above two metallization layers with a differing metal line composition and smaller pitch, in accordance with an embodiment of the present disclosure. It is to be appreciated that backside contact based die edge guard rings such as described above may be integrated with one or more layers of the integrated circuit structure described below in association with Figure 7.

Referring to Figure 7, an integrated circuit structure 700 includes a first plurality of conductive interconnect lines 704 in and spaced apart by a first inter-layer dielectric (ILD) layer 702 above a substrate 701. Individual ones of the first plurality of conductive interconnect lines 704 include a first conductive barrier material 706 along sidewalls and a bottom of a first conductive fill material 708. Individual ones of the first plurality of conductive interconnect lines 704 are along a first direction 798 (e.g., into and out of the page).

A second plurality of conductive interconnect lines 714 is in and spaced apart by a second ILD layer 712 above the first ILD layer 702. Individual ones of the second plurality of conductive interconnect lines 714 include the first conductive barrier material 706 along sidewalls and a bottom of the first conductive fill material 708. Individual ones of the second plurality of conductive interconnect lines 714 are along a second direction 799 orthogonal to the first direction 798.

A third plurality of conductive interconnect lines 724 is in and spaced apart by a third ILD layer 722 above the second ILD layer 712. Individual ones of the third plurality of conductive interconnect lines 724 include a second conductive barrier material 726 along sidewalls and a bottom of a second conductive fill material 728. The second conductive fill material 728 is different in composition from the first conductive fill material 708. Individual ones of the third plurality of conductive interconnect lines 724 are along the first direction 798.

A fourth plurality of conductive interconnect lines 734 is in and spaced apart by a fourth ILD layer 732 above the third ILD layer 722. Individual ones of the fourth plurality of conductive interconnect lines 734 include the second conductive barrier material 726 along sidewalls and a bottom of the second conductive fill material 728. Individual ones of the fourth plurality of conductive interconnect lines 734 are along the second direction 799.

A fifth plurality of conductive interconnect lines 744 is in and spaced apart by a fifth ILD layer 742 above the fourth ILD layer 732. Individual ones of the fifth plurality of conductive interconnect lines 744 include the second conductive barrier material 726 along sidewalls and a bottom of the second conductive fill material 728. Individual ones of the fifth plurality of conductive interconnect lines 744 are along the first direction 798.

A sixth plurality of conductive interconnect lines 754 is in and spaced apart by a sixth ILD layer 752 above the fifth ILD layer 742. Individual ones of the sixth plurality of conductive interconnect lines 754 include the second conductive barrier material 726 along sidewalls and a bottom of the second conductive fill material 728. Individual ones of the sixth plurality of conductive interconnect lines 754 are along the second direction 799.

In an embodiment, the second conductive fill material 728 consists essentially of copper, and the first conductive fill material 708 consists essentially of cobalt. In an embodiment, the first conductive fill material 708 includes copper having a first concentration of a dopant impurity atom, and the second conductive fill material 728 includes copper having a second concentration of the dopant impurity atom, the second concentration of the dopant impurity atom less than the first concentration of the dopant impurity atom.

In an embodiment, the first conductive barrier material 706 is different in composition from the second conductive barrier material 726. In another embodiment, the first conductive barrier material 706 and the second conductive barrier material 726 have the same composition.

In an embodiment, a first conductive via 719 is on and electrically coupled to an individual one 704A of the first plurality of conductive interconnect lines 704. An individual one 714A of the second plurality of conductive interconnect lines 714 is on and electrically coupled to the first conductive via 719.

A second conductive via 729 is on and electrically coupled to an individual one 714B of the second plurality of conductive interconnect lines 714. An individual one 724A of the third plurality of conductive interconnect lines 724 is on and electrically coupled to the second conductive via 729.

A third conductive via 739 is on and electrically coupled to an individual one 724B of the third plurality of conductive interconnect lines 724. An individual one 734A of the fourth plurality of conductive interconnect lines 734 is on and electrically coupled to the third conductive via 739.

A fourth conductive via 749 is on and electrically coupled to an individual one 734B of the fourth plurality of conductive interconnect lines 734. An individual one 744A of the fifth plurality of conductive interconnect lines 744 is on and electrically coupled to the fourth conductive via 749.

A fifth conductive via 759 is on and electrically coupled to an individual one 744B of the fifth plurality of conductive interconnect lines 744. An individual one 754A of the sixth plurality of conductive interconnect lines 754 is on and electrically coupled to the fifth conductive via 759.

In one embodiment, the first conductive via 719 includes the first conductive barrier material 706 along sidewalls and a bottom of the first conductive fill material 708. The second 729, third 739, fourth 749 and fifth 759 conductive vias include the second conductive barrier material 726 along sidewalls and a bottom of the second conductive fill material 728.

In an embodiment, the first 702, second 712, third 722, fourth 732, fifth 742 and sixth 752 ILD layers are separated from one another by a corresponding etch-stop layer 790 between adjacent ILD layers. In an embodiment, the first 702, second 712, third 722, fourth 732, fifth 742 and sixth 752 ILD layers include silicon, carbon and oxygen.

In an embodiment, individual ones of the first 704 and second 714 pluralities of conductive interconnect lines have a first width (W1). Individual ones of the third 724, fourth 734, fifth 744 and sixth 754 pluralities of conductive interconnect lines have a second width (W2) greater than the first width (W1).

It is to be appreciated that the layers and materials described above in association with back-end-of-line (BEOL) structures and processing may be formed on or above an underlying semiconductor substrate or structure, such as underlying device layer(s) of an integrated circuit. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials. The semiconductor substrate, depending on the stage of manufacture, often includes transistors, integrated circuitry, and the like. The substrate may also include semiconductor materials, metals, dielectrics, dopants, and other materials commonly found in semiconductor substrates. Furthermore, the structures depicted may be fabricated on underlying lower level interconnect layers.

Although the preceding methods of fabricating a metallization layer, or portions of a metallization layer, of a BEOL metallization layer are described in detail with respect to select operations, it is to be appreciated that additional or intermediate operations for fabrication may include standard microelectronic fabrication processes such as lithography, etch, thin films deposition, planarization (such as chemical mechanical polishing (CMP)), diffusion, metrology, the use of sacrificial layers, the use of etch stop layers, the use of planarization stop layers, or any other associated action with microelectronic component fabrication. Also, it is to be appreciated that the process operations described for the preceding process flows may be practiced in alternative sequences, not every operation need be performed or additional process operations may be performed or both.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiOz)), doped oxides of silicon, fluorinated oxides of silicon, carbon doped oxides of silicon, various low-k dielectric materials known in the arts, and combinations thereof. The interlayer dielectric material may be formed by techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials are composed of dielectric materials different from the interlayer dielectric material. In one embodiment, different hardmask materials may be used in different regions so as to provide different growth or etch selectivity to each other and to the underlying dielectric and metal layers. In some embodiments, a hardmask layer includes a layer of a nitride of silicon (e.g., silicon nitride) or a layer of an oxide of silicon, or both, or a combination thereof. Other suitable materials may include carbon-based materials. In another embodiment, a hardmask material includes a metal species. For example, a hardmask or other overlying material may include a layer of a nitride of titanium or another metal (e.g., titanium nitride). Potentially lesser amounts of other materials, such as oxygen, may be included in one or more of these layers. Alternatively, other hardmask layers known in the arts may be used depending upon the particular implementation. The hardmask layers maybe formed by CVD, PVD, or by other deposition methods.

In an embodiment, as is also used throughout the present description, lithographic operations are performed using 193nm immersion lithography (i193), extreme ultra-violet (EUV) lithography or electron beam direct write (EBDW) lithography, or the like. A positive tone or a negative tone resist may be used. In one embodiment, a lithographic mask is a tri-layer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

Embodiments disclosed herein may be used to manufacture a wide variety of different types of integrated circuits or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

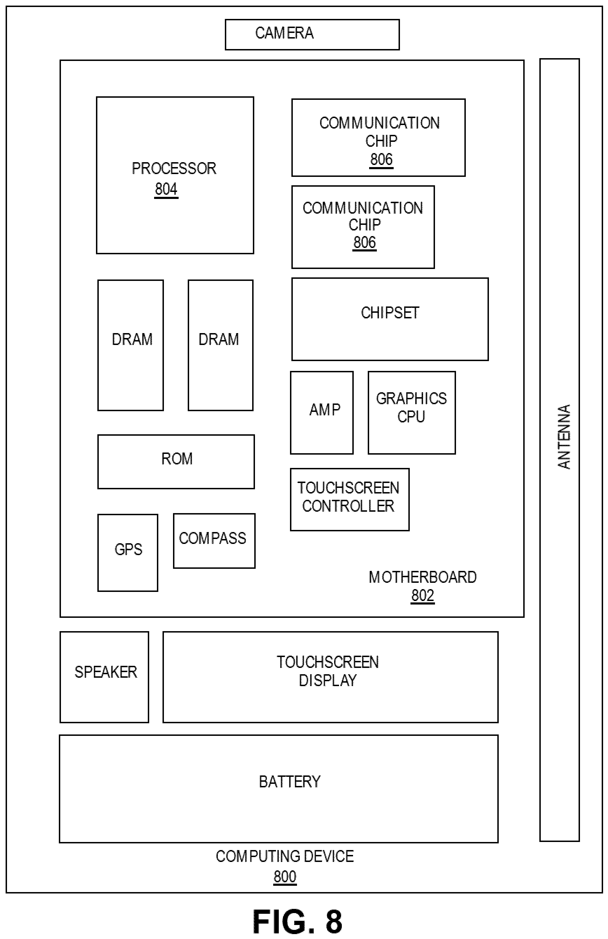

Figure 8 illustrates a computing device 800 in accordance with one implementation of the disclosure. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of embodiments of the disclosure, the processor includes backside contact based die edge guard rings built in accordance with implementations of the disclosure. The term "processor" may refer to any device or portion of a device that processes electronic data from registers or memory to transform that electronic data, or both, into other electronic data that may be stored in registers or memory, or both.

The communication chip 806 also includes an integrated circuit die packaged within the communication chip 806. In accordance with another implementation of the disclosure, the communication chip includes backside contact based die edge guard rings built in accordance with implementations of the disclosure.

In further implementations, another component housed within the computing device 800 may contain backside contact based die edge guard rings built in accordance with implementations of embodiments of the disclosure.

In various embodiments, the computing device 800 may be a laptop, a netbook, a notebook, an ultrabook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

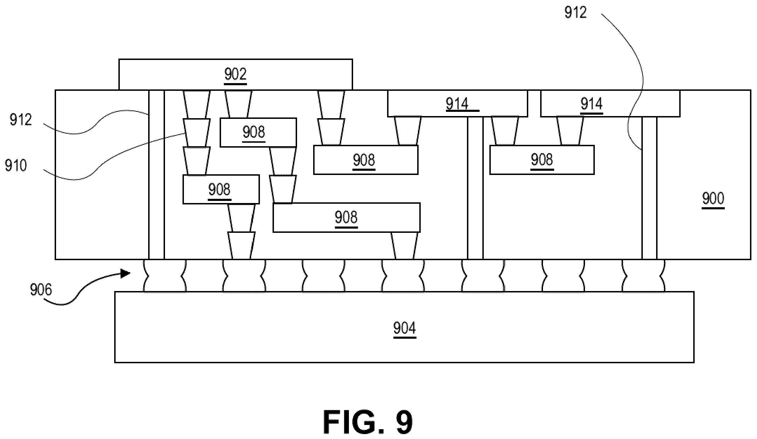

Figure 9 illustrates an interposer 900 that includes one or more embodiments of the disclosure. The interposer 900 is an intervening substrate used to bridge a first substrate 902 to a second substrate 904. The first substrate 902 may be, for instance, an integrated circuit die. The second substrate 904 may be, for instance, a memory module, a computer motherboard, or another integrated circuit die. Generally, the purpose of an interposer 900 is to spread a connection to a wider pitch or to reroute a connection to a different connection. For example, an interposer 900 may couple an integrated circuit die to a ball grid array (BGA) 906 that can subsequently be coupled to the second substrate 904. In some embodiments, the first and second substrates 902/904 are attached to opposing sides of the interposer 900. In other embodiments, the first and second substrates 902/904 are attached to the same side of the interposer 900. And, in further embodiments, three or more substrates are interconnected by way of the interposer 900.

The interposer 900 may be formed of an epoxy resin, a fiberglass-reinforced epoxy resin, a ceramic material, or a polymer material such as polyimide. In further implementations, the interposer 900 may be formed of alternate rigid or flexible materials that may include the same materials described above for use in a semiconductor substrate, such as silicon, germanium, and other group III-V and group IV materials.

The interposer 900 may include metal interconnects 908 and vias 910, including but not limited to through-silicon vias (TSVs) 912. The interposer 900 may further include embedded devices 914, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 900. In accordance with embodiments of the disclosure, apparatuses or processes disclosed herein may be used in the fabrication of interposer 900 or in the fabrication of components included in the interposer 900.

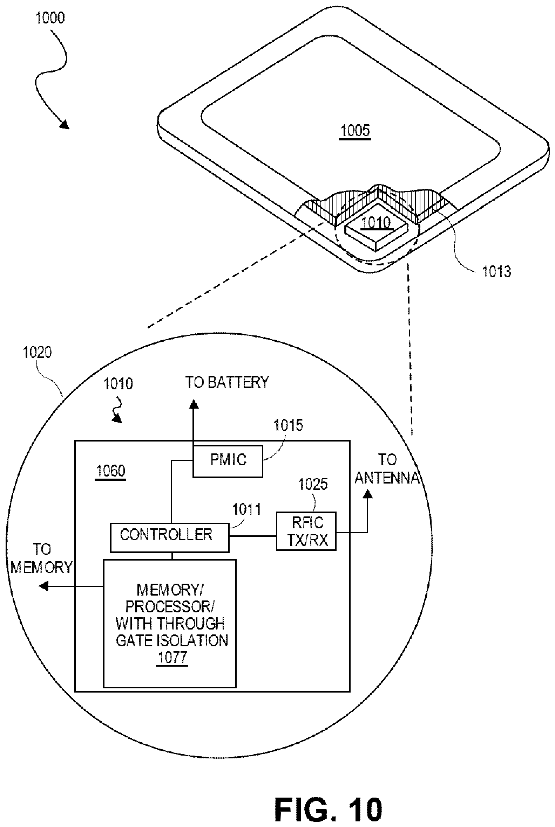

Figure 10 is an isometric view of a mobile computing platform 1000 employing an integrated circuit (IC) fabricated according to one or more processes described herein or including one or more features described herein, in accordance with an embodiment of the present disclosure.

The mobile computing platform 1000 may be any portable device configured for each of electronic data display, electronic data processing, and wireless electronic data transmission. For example, mobile computing platform 1000 may be any of a tablet, a smart phone, laptop computer, etc. and includes a display screen 1005 which in the exemplary embodiment is a touchscreen (capacitive, inductive, resistive, etc.), a chip-level (SoC) or package-level integrated system 1010, and a battery 1013. As illustrated, the greater the level of integration in the system 1010 enabled by higher transistor packing density, the greater the portion of the mobile computing platform 1000 that may be occupied by the battery 1013 or non-volatile storage, such as a solid state drive, or the greater the transistor gate count for improved platform functionality. Similarly, the greater the carrier mobility of each transistor in the system 1010, the greater the functionality. As such, techniques described herein may enable performance and form factor improvements in the mobile computing platform 1000.

The integrated system 1010 is further illustrated in the expanded view 1020. In the exemplary embodiment, packaged device 1077 includes at least one memory chip (e.g., RAM), or at least one processor chip (e.g., a multi-core microprocessor and/or graphics processor) fabricated according to one or more processes described herein or including one or more features described herein. The packaged device 1077 is further coupled to the board 1060 along with one or more of a power management integrated circuit (PMIC) 1015, RF (wireless) integrated circuit (RFIC) 1025 including a wideband RF (wireless) transmitter and/or receiver (e.g., including a digital baseband and an analog front end module further includes a power amplifier on a transmit path and a low noise amplifier on a receive path), and a controller thereof 1011. Functionally, the PMIC 1015 performs battery power regulation, DC-to-DC conversion, etc., and so has an input coupled to the battery 1013 and with an output providing a current supply to all the other functional modules. As further illustrated, in the exemplary embodiment, the RFIC 1025 has an output coupled to an antenna to provide to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of the packaged device 1077 or within a single IC (SoC) coupled to the package substrate of the packaged device 1077.

In another aspect, semiconductor packages are used for protecting an integrated circuit (IC) chip or die, and also to provide the die with an electrical interface to external circuitry. With the increasing demand for smaller electronic devices, semiconductor packages are designed to be even more compact and must support larger circuit density. Furthermore, the demand for higher performance devices results in a need for an improved semiconductor package that enables a thin packaging profile and low overall warpage compatible with subsequent assembly processing.

In an embodiment, wire bonding to a ceramic or organic package substrate is used. In another embodiment, a C4 process is used to mount a die to a ceramic or organic package substrate. In particular, C4 solder ball connections can be implemented to provide flip chip interconnections between semiconductor devices and substrates. A flip chip or Controlled Collapse Chip Connection (C4) is a type of mounting used for semiconductor devices, such as integrated circuit (IC) chips, MEMS or components, which utilizes solder bumps instead of wire bonds. The solder bumps are deposited on the C4 pads, located on the top side of the substrate package. In order to mount the semiconductor device to the substrate, it is flipped over with the active side facing down on the mounting area. The solder bumps are used to connect the semiconductor device directly to the substrate.

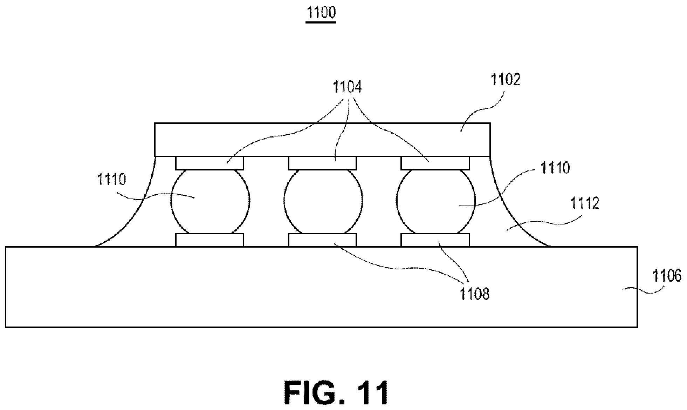

Figure 11 illustrates a cross-sectional view of a flip-chip mounted die, in accordance with an embodiment of the present disclosure.

Referring to Figure 11, an apparatus 1100 includes a die 1102 such as an integrated circuit (IC) fabricated according to one or more processes described herein or including one or more features described herein, in accordance with an embodiment of the present disclosure. The die 1102 includes metallized pads 1104 thereon. A package substrate 1106, such as a ceramic or organic substrate, includes connections 1108 thereon. The die 1102 and package substrate 1106 are electrically connected by solder balls 1110 coupled to the metallized pads 1104 and the connections 1108. An underfill material 1112 surrounds the solder balls 1110.

Processing a flip chip may be similar to conventional IC fabrication, with a few additional operations. Near the end of the manufacturing process, the attachment pads are metalized to make them more receptive to solder. This typically consists of several treatments. A small dot of solder is then deposited on each metalized pad. The chips are then cut out of the wafer as normal. To attach the flip chip into a circuit, the chip is inverted to bring the solder dots down onto connectors on the underlying electronics or circuit board. The solder is then re-melted to produce an electrical connection, typically using an ultrasonic or alternatively reflow solder process. This also leaves a small space between the chip's circuitry and the underlying mounting. In most cases an electrically-insulating adhesive is then "underfilled" to provide a stronger mechanical connection, provide a heat bridge, and to ensure the solder joints are not stressed due to differential heating of the chip and the rest of the system.

In other embodiments, newer packaging and die-to-die interconnect approaches, such as through silicon via (TSV) and silicon interposer, are implemented to fabricate high performance Multi-Chip Module (MCM) and System in Package (SiP) incorporating an integrated circuit (IC) fabricated according to one or more processes described herein or including one or more features described herein, in accordance with an embodiment of the present disclosure.

Thus, embodiments of the present disclosure include backside contact based die edge guard rings.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.

Example embodiment 1: A semiconductor die includes an active device layer including a plurality of nanoribbon devices. A dielectric structure is over the active device layer. A first die-edge metal guard ring is in the dielectric structure and around an outer perimeter of the plurality of nanoribbon devices. A plurality of metallization layers is in the dielectric structure and within the first die-edge metal guard ring. A plurality of direct backside contacts extend to the active device layer. A plurality of backside metallization structures is beneath the plurality of direct backside contacts. The plurality of direct backside contacts are connected to the plurality of backside metallization structures. A second die-edge metal guard ring is laterally around the plurality of backside metallization structures.

Example embodiment 2: The semiconductor die of example embodiment 1, wherein the first die-edge metal guard ring is a first square or rectangular frame, and the second die-edge metal guard ring is a second square or rectangular frame.

Example embodiment 3: The semiconductor die of example embodiment 1 or 2, wherein the first die-edge metal guard ring and the second die-edge metal guard ring each include multiple layers of alternating metal lines and vias.

Example embodiment 4: The semiconductor die of example embodiment 1, 2 or 3, wherein the first die-edge metal guard ring includes a trench contact.

Example embodiment 5: The semiconductor die of example embodiment 1, 2, 3 or 4, further including a second plurality of direct backside contacts coupling the first die-edge metal guard ring to the second die-edge metal guard ring.

Example embodiment 6: A semiconductor die includes an active device layer including a plurality of fins. A dielectric structure is over the active device layer. A first die-edge metal guard ring is in the dielectric structure and around an outer perimeter of the fins. A plurality of metallization layers is in the dielectric structure and within the first die-edge metal guard ring. A plurality of direct backside contacts extend to the active device layer. A plurality of backside metallization structures is beneath the plurality of direct backside contacts. The plurality of direct backside contacts are connected to the plurality of backside metallization structures. A second die-edge metal guard ring is laterally around the plurality of backside metallization structures.

Example embodiment 7: The semiconductor die of example embodiment 6, wherein the first die-edge metal guard ring is a first square or rectangular frame, and the second die-edge metal guard ring is a second square or rectangular frame.

Example embodiment 8: The semiconductor die of example embodiment 6 or 7, wherein the first die-edge metal guard ring and the second die-edge metal guard ring each include multiple layers of alternating metal lines and vias.

Example embodiment 9: The semiconductor die of example embodiment 6, 7 or 8, wherein the first die-edge metal guard ring includes a trench contact.

Example embodiment 10: The semiconductor die of example embodiment 6, 7, 8 or 9, further including a second plurality of direct backside contacts coupling the first die-edge metal guard ring to the second die-edge metal guard ring.

Example embodiment 11: A computing device includes a board, and a component coupled to the board. The component includes an integrated circuit structure including an active device layer including a plurality of nanoribbon devices or fin-based devices. A dielectric structure is over the active device layer. A first die-edge metal guard ring is in the dielectric structure and around an outer perimeter of the plurality of nanoribbon or fin-based devices. A plurality of metallization layers is in the dielectric structure and within the first die-edge metal guard ring. A plurality of direct backside contacts extend to the active device layer. A plurality of backside metallization structures is beneath the plurality of direct backside contacts. The plurality of direct backside contacts are connected to the plurality of backside metallization structures. A second die-edge metal guard ring is laterally around the plurality of backside metallization structures.

Example embodiment 12: The computing device of example embodiment 11, including the plurality of nanoribbon devices.

Example embodiment 13: The computing device of example embodiment 11 or 12, including the plurality of fin-based devices.

Example embodiment 14: The computing device of example embodiment 11, 12 or 13, further including a memory coupled to the board.

Example embodiment 15: The computing device of example embodiment 11, 12, 13 or 14, further including a communication chip coupled to the board.

Example embodiment 16: The computing device of example embodiment 11, 12, 13, 14 or 15, further including a battery coupled to the board.

Example embodiment 17: The computing device of example embodiment 11, 12, 13, 14, 15 or 16, further including a camera coupled to the board.

Example embodiment 18: The computing device of example embodiment 11, 12, 13, 14, 15, 16 or 17, further including a display coupled to the board.

Example embodiment 19: The computing device of example embodiment 11, 12, 13, 14, 15, 16, 17 or 18, wherein the component is a packaged integrated circuit die.

Example embodiment 20: The computing device of example embodiment 11, 12, 13, 14, 15, 16, 17, 18 or 19, wherein the component is selected from the group consisting of a processor, a communications chip, and a digital signal processor.

## Claims

1. A semiconductor die, comprising:
an active device layer having a plurality of nanoribbon devices;
a dielectric structure over the active device layer;
a first die-edge metal guard ring in the dielectric structure and around an outer perimeter of the plurality of nanoribbon devices;
a plurality of metallization layers in the dielectric structure and within the first die-edge metal guard ring;
a plurality of direct backside contacts that extend to the active device layer;
a plurality of backside metallization structures beneath the plurality of direct backside contacts, wherein the plurality of direct backside contacts are connected to the plurality of backside metallization structures; and
a second die-edge metal guard ring laterally around the plurality of backside metallization structures.

2. The semiconductor die of claim 1, wherein the first die-edge metal guard ring is a first square or rectangular frame, and the second die-edge metal guard ring is a second square or rectangular frame.

3. The semiconductor die of claim 1 or 2, wherein the first die-edge metal guard ring and the second die-edge metal guard ring each comprise multiple layers of alternating metal lines and vias.

4. The semiconductor die of claim 1, 2 or 3, wherein the first die-edge metal guard ring includes a trench contact.

5. The semiconductor die of claim 1, 2, 3 or 4, further comprising:
a second plurality of direct backside contacts coupling the first die-edge metal guard ring to the second die-edge metal guard ring.

6. A method of fabricating a semiconductor die, the method comprising:
forming an active device layer having a plurality of nanoribbon devices;
forming a dielectric structure over the active device layer;
forming a first die-edge metal guard ring in the dielectric structure and around an outer perimeter of the plurality of nanoribbon devices;
forming a plurality of metallization layers in the dielectric structure and within the first die-edge metal guard ring;
forming a plurality of direct backside contacts that extend to the active device layer;
forming a plurality of backside metallization structures beneath the plurality of direct backside contacts, wherein the plurality of direct backside contacts are connected to the plurality of backside metallization structures; and
forming a second die-edge metal guard ring laterally around the plurality of backside metallization structures.

7. The method of claim 6, wherein the first die-edge metal guard ring is a first square or rectangular frame, and the second die-edge metal guard ring is a second square or rectangular frame.

8. The method of claim 6 or 7, wherein the first die-edge metal guard ring and the second die-edge metal guard ring each comprise multiple layers of alternating metal lines and vias.

9. The method of claim 6, 7 or 8, wherein the first die-edge metal guard ring includes a trench contact.

10. The method of claim 6, 7, 8 or 9, further comprising:
forming a second plurality of direct backside contacts coupling the first die-edge metal guard ring to the second die-edge metal guard ring.
